# EUROPEAN PATENT APPLICATION

(11) **EP 4 611 025 A2**
(43) Date of publication of application: **03.09.2025**
(21) Application number: 25155950.6
(22) Date of filing: 05.02.2025
(51) Int. Cl.: H01L 21/66

(54) **SEMICONDUCTOR DEVICE**

(30) Priority: 06.02.2024 US 202463550567 P
(71) Applicant: MediaTek Inc., Hsinchu City, 30078 (TW)
(72) Inventor: JHAN, Cing-Yao, 30078 Hsinchu City (TW); HUANG, Chien-Kai, 30078 Hsinchu City (TW); SHIH, Ting-Chen, 30078 Hsinchu City (TW); HU, Chu-Wei, 30078 Hsinchu City (TW)
(74) Representative: Wright, Howard Hugh Burnby

(57) **Abstract**

A semiconductor device includes a substrate, an outer detection wire and an inner detection wire. The substrate has a periphery lateral surface. The outer detection wire is disposed on the substrate and adjacent to the periphery lateral surface. The inner detection wire is disposed on the substrate, adjacent to the periphery lateral surface, and isolated from the outer detection wire. The outer detection wire is closer to the periphery lateral surface than the inner detection wire.

## Description

### TECHNICAL FIELD

The invention relates to a device, and more particularly to a semiconductor device.

### BACKGROUND OF THE INVENTION

Conventional semiconductor device may be damaged by the crack resulted from the temperature, external force action, etc. If the crack continues to grow, it will damage at least one component (conductive trace, conductive via, circuit, active chip, passive component, layer structure, molding compound, etc.) in the semiconductor device. Thus, how to detect the crack occurring in the semiconductor device has become a prominent task for the industries.

### SUMMARY OF THE INVENTION

In an embodiment of the invention, a semiconductor device is provided. The semiconductor device includes a substrate, an outer detection wire an inner detection wire. The substrate has a periphery lateral surface. The outer detection wire is disposed on the substrate and adjacent to the periphery lateral surface. The inner detection wire is disposed on the substrate, adjacent to the periphery lateral surface, and isolated from the outer detection wire. The outer detection wire is closer to the periphery lateral surface than the inner detection wire.

Numerous objects, features and advantages of the invention will be readily apparent upon a reading of the following detailed description of embodiments of the invention when taken in conjunction with the accompanying drawings. However, the drawings employed herein are for the purpose of descriptions and should not be regarded as limiting.

### BRIEF DESCRIPTION OF THE DRAWINGS

The above objects and advantages of the invention will become more readily apparent to those ordinarily skilled in the art after reviewing the following detailed description and accompanying drawings, in which:
FIG. 1A illustrates a schematic diagram of a top view of a semiconductor device according to an embodiment of the invention;
FIG. 1B illustrates a cross-sectional view of the semiconductor device 100 in FIG. 1A along a direction 1B-1B';
FIG. 1C illustrates a cross-sectional view of the semiconductor device in FIG. 1A along a direction 1C-1C';
FIG. 2A illustrates a schematic diagram of a top view of a semiconductor device according to another embodiment of the invention;
FIG. 2B illustrates a cross-sectional view of the semiconductor device in FIG. 2A along a direction 2B-2B';
FIG. 2C illustrates a cross-sectional view of the semiconductor device in FIG. 2A along a direction 2C-2C';
FIG. 3 illustrates a schematic diagram of a top view of a semiconductor device according to another embodiment of the invention;
FIG. 4 illustrates a schematic diagram of a top view of a semiconductor device according to another embodiment of the invention; and
FIG. 5 illustrates a schematic diagram of a top view of a semiconductor device according to another embodiment of the invention.

### DETAILED DESCRIPTION OF PREFERRED EMBODIMENTS

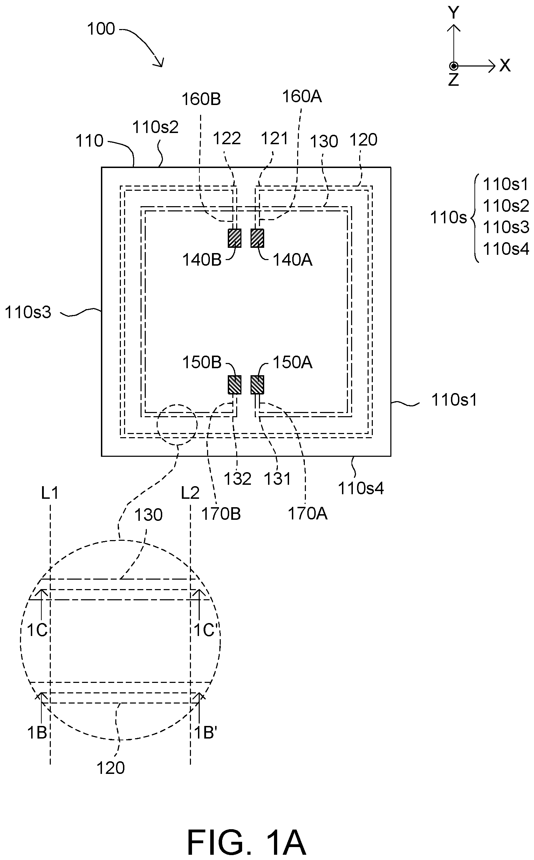

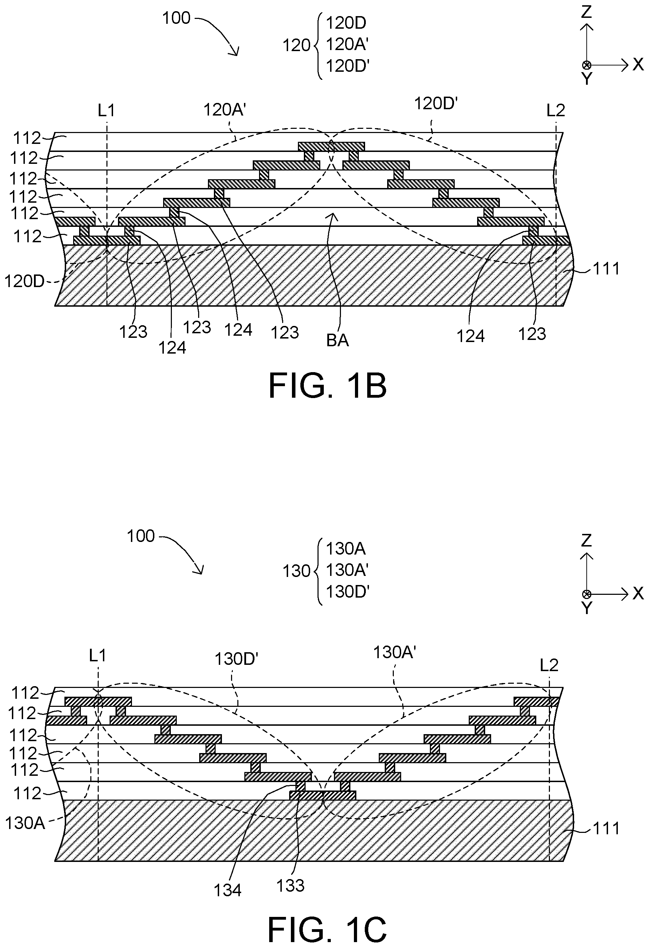

Referring to FIGS. 1A to 1B, FIG. 1A illustrates a schematic diagram of a top view of a semiconductor device 100 according to an embodiment of the invention, FIG. 1B illustrates a cross-sectional view of the semiconductor device 100 in FIG. 1A along a direction 1B-1B', and FIG. 1C illustrates a cross-sectional view of the semiconductor device 100 in FIG. 1A along a direction 1C-1C'. The semiconductor device 100 is, for example, a semiconductor chip, a semiconductor die, a semiconductor package, etc.

As illustrated in FIGS. 1A to 1C, the semiconductor device 100 includes a substrate 110, an outer detection wire 120, an inner detection wire 130, a first pad 140A, a second pad 140B, a third pad 150A, a fourth pad 150B, a first outer connection wire 160A, a second outer connection wire 160B, a first inner connection wire 170A and a second inner connection wire 170B. The substrate 110 has a periphery lateral surface 110s. The outer detection wire 120 is disposed on the substrate 110 and adjacent to the periphery lateral surface 110s. The inner detection wire 130 is disposed on the substrate 110, adjacent to the periphery lateral surface 110s, and isolated from the outer detection wire 120. The outer detection wire 120 is closer to the periphery lateral surface 110s than the inner detection wire 130. As a result, a crack (if any) occurring in the semiconductor device 100 may be detected through the outer detection wire 120 and/or the inner detection wire 130. Since the crack can be detected early, users may/can deal with the crack problem as soon as possible.

As illustrated in FIG. 1A, the periphery lateral surface 110s has four sub-periphery lateral surfaces, for example, a first sub-periphery lateral surface 110s1, a second sub-periphery lateral surface 110s2, a third sub-periphery lateral surface 110s3 and a fourth sub-periphery lateral surface 110s4. The first sub-periphery lateral surface 110s1, the second sub-periphery lateral surface 110s2, the third sub-periphery lateral surface 110s3 and the fourth sub-periphery lateral surface 110s4 define the entire outer boundary of the substrate 110 or the semiconductor device 100. The outer detection wire 120 and the inner detection wire 130 extend adjacent to the four sub-periphery lateral surfaces 110s1 to 110s4.

As illustrated in FIG. 1A, the first pad 140A is disposed on and exposed from the substrate 110. The first outer connection wire 160A connects the first pad 140A with a first end 121 of the outer detection wire 120. The second pad 140B is disposed on and exposed from the substrate 110. The second outer connection wire 160B connects the second pad 140B with a second end 122 of the outer detection wire 120. The first outer connection wire 160A and/or the second outer connection wire 160B may include the features the same as or similar to that of the outer detection wire 120.

As illustrated in FIG. 1A, the third pad 150A is disposed on and exposed from the substrate 110. The first inner connection wire 170A connects the third pad 150A with a first end 131 of the inner detection wire 130. The fourth pad 150B is disposed on and exposed from the substrate 110. The second inner connection wire 170B connects the fourth pad 150B with a second end 132 of the inner detection wire 130. The first inner connection wire 170A and/or the second inner connection wire 170B may include the features the same as or similar to that of the inner detection wire 130.

A detector (not illustrated) may probe the first pad 140A and the second pad 140B. If a crack breaks the outer detection wire 120, the detector and the outer detection wire 120 can't form an electrical loop, and thus the crack may be found by the detector. Similarly, the detector may probe the third pad 150A and the fourth pad 150B. If a crack breaks the inner detection wire 130, the detector and the inner detection wire 130 can't form an electrical loop, and thus the crack may be found by the detector.

Furthermore, if a crack occurs in the semiconductor device 100, the crack may damage the outer detection wire 120, and it will cause the outer detection wire 120 to break. The broken outer detection wire 120 may be detected by a detector (not illustrated) probing the first pad 140A and the second pad 140B. Similarly, if a crack occurs in the semiconductor device 100, the crack may damage the inner detection wire 130, and it will cause the inner detection wire 130 to break. The broken inner detection wire 130 may be detected by a detector probing the third pad 150A and the fourth pad 150B.

As illustrated in FIG. 1B, the substrate 110 includes a base 111 and a plurality of dielectric layers 112 disposed on the base 111 and stacked to each other. The base 111 is, for example, a portion of a silicon wafer. The outer detection wire 120 includes a plurality of outer conductive traces 123 and a plurality of conductive vias 124, each outer conductive trace 123 is disposed on the corresponding dielectric layer 112, and one of the conductive vias 124 connects the adjacent two of the outer conductive traces 123.

As illustrated in FIG. 1B, in an embodiment, the outer detection wire 120 may extend in undulating way. Furthermore, the outer detection wire 120 may include at least one outer ascending segment 120A' and at least one outer descending segment 120D, wherein the adjacent outer ascending segment 120A' and outer descending segment 120D are connected with each other. Each outer ascending segment 120A' ascends in a first extension path substantial parallel to the periphery lateral surface 110s (for example, the first sub-periphery lateral surface 110s1, the second sub-periphery lateral surface 110s2, the third sub-periphery lateral surface 110s3 and the fourth sub-periphery lateral surface 110s4), and each outer descending segment 120D descends in the first extension path substantial parallel to the periphery lateral surface 110s.

As illustrated in FIG. 1B, the adjacent two segments which are directly connected are the outer ascending segment 120A' and the outer descending segment 120D respectively. Furthermore, in the adjacent outer descending segment 120D and outer ascending segment 120A', the outer descending segment 120D is connected with the outer ascending segment 120A' at the bottommost one of the dielectric layers 112. In the adjacent outer ascending segment 120A' and outer descending segment 120D', the outer ascending segment 120A' is connected with the outer descending segment 120D' at the topmost one of the dielectric layers 112.

As illustrated in FIG. 1B, each outer ascending segment 120A' may extend through all dielectric layers 112, and each outer descending segment 120D may extend through all dielectric layers 112. As a result, a crack which occurs in any of the dielectric layers 112 may be detected.

As illustrated in FIG. 1C, the inner detection wire 130 includes a plurality of inner conductive traces 133 and a plurality of conductive vias 134, each inner conductive trace 133 is disposed on the corresponding dielectric layer 112, and one of the conductive vias 134 connects the adjacent two of the inner conductive traces 133.

As illustrated in FIG. 1C, in an embodiment, the inner detection wire 130 may extend in undulating way. Furthermore, the inner detection wire 130 may include at least one inner ascending segment 130A and at least one inner descending segment 130D, wherein the adjacent inner ascending segment 130A and outer inner descending segment 130D are connected with each other. Each inner ascending segment 130A ascends in the first extension path substantial parallel to the periphery lateral surface 110s, and each inner descending segment 130D descends in the first extension path substantial parallel to the periphery lateral surface 110s.

As illustrated in FIG. 1C, the adjacent two segments which are directly connected are the inner ascending segment 130A and the inner descending segment 130D respectively. Furthermore, in the adjacent inner descending segment 130D' and inner ascending segment 130A, the inner descending segment 130D' is connected with the inner ascending segment 130A at the topmost one of the dielectric layers 112. In the adjacent inner ascending segment 130A' and inner descending segment 130D', the inner ascending segment 130A' is connected with the inner descending segment 130D' at the bottommost one of the dielectric layers 112.

As illustrated in FIG. 1C, each inner ascending segment 130A may extend through all dielectric layers 112, and each inner descending segment 130D may extend through all dielectric layers 112. As a result, a crack which occurs in any of the dielectric layers 112 may be detected.

As illustrated in FIGS. 1B and 1C, the ascending segment of the outer detection wire is corresponding to the descending segment of the inner detection wire. Furthermore, in the same region from a reference line L1 to a reference line L2, the outer ascending segment 120A' is corresponding to the inner descending segment 130D', and the outer descending segment 120D' is corresponding to the inner ascending segment 130A'. As a result, although the lower dielectric layers 112 (or called "blank area BA") lacks the segment of the outer detection wire 120 in FIG. 1B, the inner descending segment 130D and the inner ascending segment 130A in FIG. 1C may complement the blank area BA since the inner descending segment 130D and the inner ascending segment 130A in FIG. 1C are corresponding to the blank area BA in FIG. 1B.

In another embodiment, the ascending segment of the outer detection wire 120 may be corresponding to the ascending segment of the inner detection wire 130. In other embodiment, the ascending segment of the outer detection wire 120 may be corresponding to a portion of the ascending segment and a portion of the descending segment of the inner detection wire 130.

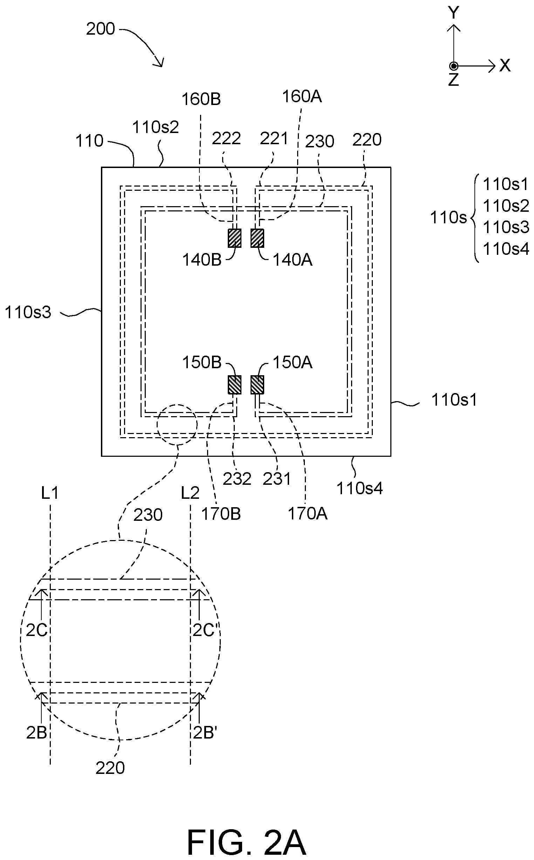

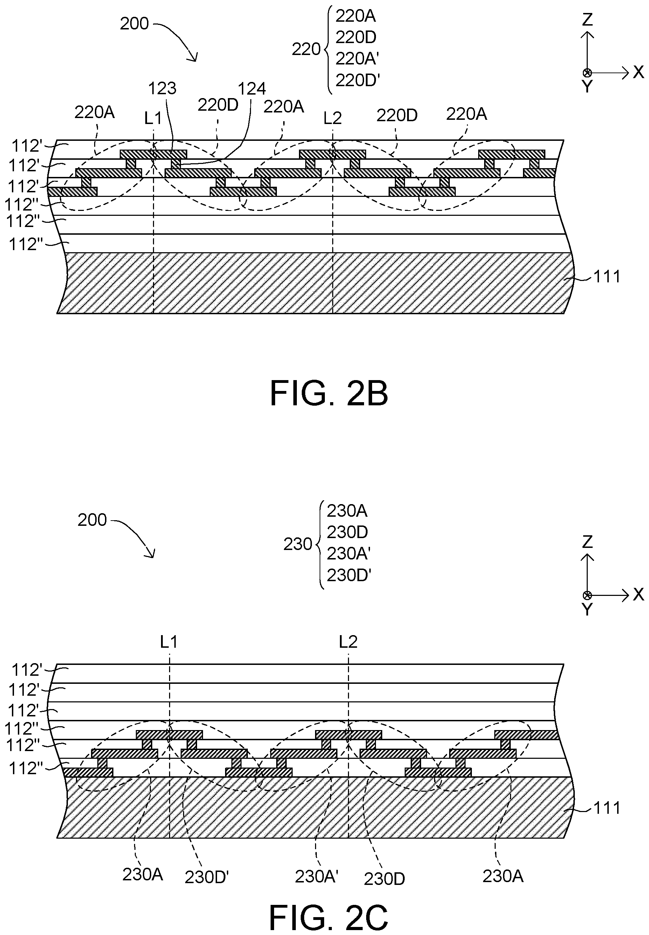

Referring to FIGS. 2A to 2C, FIG. 2A illustrates a schematic diagram of a top view of a semiconductor device 200 according to another embodiment of the invention, FIG. 2B illustrates a cross-sectional view of the semiconductor device 200 in FIG. 2A along a direction 2B-2B', and FIG. 2C illustrates a cross-sectional view of the semiconductor device 200 in FIG. 2A along a direction 2C-2C'.

As illustrated in FIGS. 2A to 2C, the semiconductor device 200 includes the substrate 110, an outer detection wire 220, an inner detection wire 230, the first pad 140A, the second pad 140B, the third pad 150A, the fourth pad 150B, the first outer connection wire 160A, the second outer connection wire 160B, the first inner connection wire 170A and the second inner connection wire 170B.

As illustrated in FIGS. 2B and 2C, the outer detection wire 220 is disposed on the substrate 110 and adjacent to the periphery lateral surface 110s. The inner detection wire 230 is disposed on the substrate 110, adjacent to the periphery lateral surface 110s, and isolated from the outer detection wire 220. The outer detection wire 220 is closer to the periphery lateral surface 110s than the inner detection wire 230. As a result, a crack (if any) occurring in the semiconductor device 200 may be detected through the outer detection wire 220 and/or the inner detection wire 230.

As illustrated in FIG. 2A, the first pad 140A is disposed on and exposed from the substrate 110. The first outer connection wire 160A connects the first pad 140A with a first end 221 of the outer detection wire 220. The second pad 140B is disposed on and exposed from the substrate 110. The second pad 140B is disposed on and exposed from the substrate 110. The second outer connection wire 160B connects the second pad 140B with a second end 222 of the outer detection wire 220. The first outer connection wire 160A and/or the second outer connection wire 160B may include the features the same as or similar to that of the outer detection wire 220.

As illustrated in FIG. 2A, the third pad 150A is disposed on and exposed from the substrate 110. The first inner connection wire 170A connects the third pad 150A with a first end 231 of the inner detection wire 230. The fourth pad 150B is disposed on and exposed from the substrate 110. The second inner connection wire 170B connects the fourth pad 150B with a second end 232 of the inner detection wire 230. The first inner connection wire 170A and/or the second inner connection wire 170B may include the features the same as or similar to that of the inner detection wire 230.

A detector (not illustrated) may probe the first pad 140A and the second pad 140B. If a crack breaks the outer detection wire 220, the detector and the outer detection wire 220 can't form an electrical loop, and thus the crack may be found by the detector. Similarly, the detector may probe the third pad 150A and the fourth pad 150B. If a crack breaks the inner detection wire 230, the detector and the inner detection wire 230 can't form an electrical loop, and thus the crack may be found by the detector.

Furthermore, if a crack occurs in the semiconductor device 200, the crack may damage the outer detection wire 220, and it will cause the outer detection wire 220 to break. The broken outer detection wire 220 may be detected by a detector (not illustrated) probing the first pad 140A and the second pad 140B. Similarly, if a crack occurs in the semiconductor device 200, the crack may damage the inner detection wire 230, and it will cause the inner detection wire 230 to break. The broken inner detection wire 230 may be detected by a detector probing the third pad 150A and the fourth pad 150B.

As illustrated in FIG. 2B, the substrate 110 includes the base 111 and a plurality of dielectric layers (112' and 112") disposed on the base 111 and stacked to each other.

The semiconductor device 200 includes the features the same as or similar to that of the semiconductor device 100, and at least one difference is that the outer detection wire 220 and/or the inner detection wire 230 does not extend through all of the dielectric layers. Furthermore, the outer detection wire 220 and the inner detection wire 230 together extend through all of the dielectric layers. For example, the outer detection wire 220 may extend through the upper dielectric layers 112', and the inner detection wire 230 may extend through the lower dielectric layers 112".

As illustrated in FIG. 2B, in an embodiment, the outer detection wire 220 may extend in undulating way. Furthermore, the outer detection wire 220 may include at least one outer ascending segment 220A and at least one outer descending segment 220D, wherein the adjacent outer ascending segment 220A and outer descending segment 220D are connected with each other. Each outer ascending segment 220A' ascends in the first extension path substantial parallel to the periphery lateral surface 110s, and each outer descending segment 220D descends in the first extension path substantial parallel to the periphery lateral surface 110s.

As illustrated in FIG. 2B, the adjacent two segments which are directly connected are the outer ascending segment 220A and the outer descending segment 220D respectively. Furthermore, in the adjacent outer ascending segment 220A and outer descending segment 220D', the outer ascending segment 220A is connected with the and the outer descending segment 220D' at the topmost one of the upper dielectric layers 112'. In the adjacent outer descending segments 220D' and outer ascending segments 220A', the outer descending segments 220D' is connected with the outer ascending segments 220A' at the bottommost one of the upper dielectric layers 112'.

As illustrated in FIG. 2C, in an embodiment, the inner detection wire 230 may extend in undulating way. Furthermore, the inner detection wire 230 may include at least one inner ascending segment 230A and at least one inner descending segment 230D, wherein the adjacent inner ascending segment 230A and inner descending segment 230D are connected with each other. Each inner ascending segment 230A ascends in the first extension path substantial parallel to the periphery lateral surface 110s, and each inner descending segment 230D descends in the first extension path substantial parallel to the periphery lateral surface 110s.

As illustrated in FIG. 2C, the adjacent two segments which are directly connected are the inner ascending segment 230A and the inner descending segment 230D respectively. Furthermore, in the adjacent inner ascending segment 230A and inner descending segment 230D' and, the inner ascending segment 230A is connected with the inner descending segment 230D' at the topmost one of the lower dielectric layers 112". In the adjacent inner descending segment 230D' and inner ascending segment 230A', the inner descending segment 230D' and the inner ascending segment 230A' is connected with at the bottommost one of the lower dielectric layers 112".

As illustrated in FIGS. 2B and 2C, the ascending segment of the outer detection wire is corresponding to the ascending segment of the inner detection wire. Furthermore, in the same region from the reference line L1 to the reference line L2, the outer descending segment 220D' is corresponding to the inner descending segment 230D', and the outer ascending segment 220A' is corresponding to the inner ascending segment 230A'. In another embodiment, in in the same region from the reference line L1 to the reference line L2, the outer descending segment 220D' is corresponding to the inner ascending segment 230A', and the outer ascending segment 220A' is corresponding to the inner descending segment 230D'.

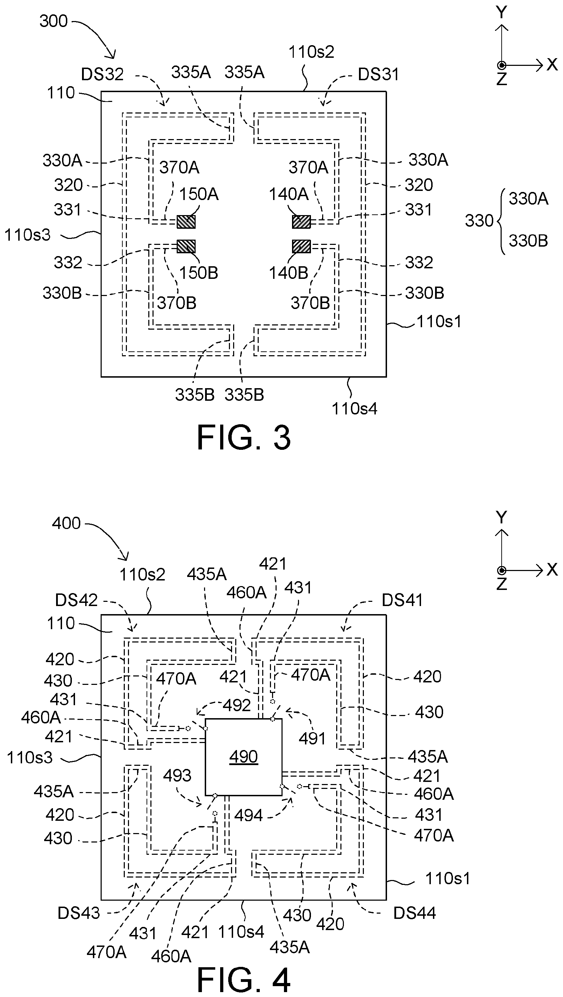

Referring to FIG. 3, FIG. 3 illustrates a schematic diagram of a top view of a semiconductor device 300 according to another embodiment of the invention. The semiconductor device 300 includes the substrate 110, a first detection set DS31, a second detection set DS32, the first pad 140A, the second pad 140B, the third pad 150A, the fourth pad 150B. Each of the first detection set DS31 and the second detection set DS32 includes an outer detection wire 320 and an inner detection wire 330. The outer detection wire 320 may include the feature the same as or similar to that of the outer detection wire 120 or the outer detection wire 220. The inner detection wire 330 may include the feature the same as or similar to that of the outer detection wire 130 or the outer detection wire 230.

As illustrated in FIG. 3, the first detection set DS31 includes the outer detection wire 320, the inner detection wire 330, a first inner connection wire 370A, a second inner connection wire 370B, a first inner-outer connection wire 335A and a second inner-outer connection wire 335B. The inner detection wire 330 includes a first-sub inner detection wire 330A and a second-sub inner detection wire 330B. The first inner connection wire 370A connects the first pad 140A with a first end 331 of the first-sub inner detection wire 330A of the inner detection wire 330. The second inner connection wire 370B connects the second pad 140B with a second end 332 of the second-sub inner detection wire 330B of the inner detection wire 330. The first inner-outer connection wire 335A connects the outer detection wire 320 with the first-sub inner detection wire 330A of the inner detection wire 330. The second inner-outer connection wire 335B connects the outer detection wire 320 with the second-sub inner detection wire 330B of the inner detection wire 330.

In the present embodiment, the first inner connection wire 370A, the second inner connection wire 370B and/or the second inner-outer connection wire 335B may include the features the same as or similar to that of the inner detection wire 130 or the inner detection wire 230. The first inner-outer connection wire 335A may include the features the same as or similar to that of the detection wire (the outer detection wire or the inner detection wire).

As illustrated in FIG. 3, in the first detection set DS31, the outer detection wire 320 extends adjacent to the first sub-periphery lateral surface 110s1, the second sub-periphery lateral surface 110s2 and the fourth sub-periphery lateral surface 110s4, the first-sub inner detection wire 330A extends adjacent to the first sub-periphery lateral surface 110s1 and the second sub-periphery lateral surface 110s2, and the second-sub inner detection wire 330B extends adjacent to the first sub-periphery lateral surface 110s1 and the fourth sub-periphery lateral surface 110s4. In the first detection set DS31, the outer detection wire 320, the first-sub inner detection wire 330A and the second-sub inner detection wire 330B may extend in the first extension path substantial parallel to the first sub-periphery lateral surface 110s1, the second sub-periphery lateral surface 110s2 and the fourth sub-periphery lateral surface 110s4. In the first detection set DS31, the first inner-outer connection wire 335A may extend in a second extension path substantial vertical to the second sub-periphery lateral surface 110s2, and the second inner-outer connection wire 335B may extend in a fourth extension path substantial vertical to the fourth sub-periphery lateral surface 110s4.

As illustrated in FIG. 3, the second detection set DS32 includes the outer detection wire 320, the inner detection wire 330, the first inner connection wire 370A, the second inner connection wire 370B, the first inner-outer connection wire 335A and the second inner-outer connection wire 335B. The inner detection wire 330 includes the first-sub inner detection wire 330A and the second-sub inner detection wire 330B. The first inner connection wire 370A connects the third pad 150A with the first end 331 of the first-sub inner detection wire 330A of the inner detection wire 330. The second inner connection wire 370B connects the fourth pad 150B with the second end 332 of the second-sub inner detection wire 330B of the inner detection wire 330. The first inner-outer connection wire 335A connects the outer detection wire 320 with the first-sub inner detection wire 330A of the inner detection wire 330. The second inner-outer connection wire 335B connects the outer detection wire 320 with the second-sub inner detection wire 330B of the inner detection wire 330.

As illustrated in FIG. 3, in the second detection set DS32, the outer detection wire 320 extends adjacent to the second sub-periphery lateral surface 110s2, the third sub-periphery lateral surface 110s3 and the fourth sub-periphery lateral surface 110s4, the first-sub inner detection wire 330A extends adjacent to the second sub-periphery lateral surface 110s2 and the third sub-periphery lateral surface 110s3, and the second-sub inner detection wire 330B extends adjacent to the third sub-periphery lateral surface 110s3 and the fourth sub-periphery lateral surface 110s4. In the second detection set DS32, the outer detection wire 320, the first-sub inner detection wire 330A and the second-sub inner detection wire 330B may extend in the second sub-periphery lateral surface 110s2, the third sub-periphery lateral surface 110s3 and the fourth sub-periphery lateral surface 110s4. In the second detection set DS32, the first inner-outer connection wire 335A may extend in the second extension path substantial vertical to the second sub-periphery lateral surface 110s2, and the second inner-outer connection wire 335B may extend in the fourth extension path substantial vertical to the fourth sub-periphery lateral surface 110s4.

A detector (not illustrated) may probe the first pad 140A and the second pad 140B. If a crack breaks the outer detection wire 320 and/or the inner detection wire 330 in the first detection set DS31, the detector and the first detection set DS31 can't form an electrical loop, and thus the crack may be found by the detector. Similarly, the detector may probe the third pad 150A and the fourth pad 150B. If a crack breaks the inner detection wire 330 and/or the inner detection wire 330 in the second detection set DS32, the detector and the second detection set DS32 can't form an electrical loop, and thus the crack may be found by the detector.

Referring to FIG. 4, FIG. 4 illustrates a schematic diagram of a top view of a semiconductor device 400 according to another embodiment of the invention. The semiconductor device 400 includes the substrate 110, a first detection set DS41, a second detection set DS42, a third detection set DS43, a fourth detection set DS44 and a switch 490. Each of the first detection set DS41, the second detection set DS42, the third detection set DS43 and the fourth detection set DS44 includes an outer detection wire 420 and an inner detection wire 430. The outer detection wire 420 may include the feature the same as or similar to that of the outer detection wire 120 or the outer detection wire 220. The inner detection wire 430 may include the feature the same as or similar to that of the outer detection wire 130 or the outer detection wire 230.

In the present embodiment, at least one of the first detection set DS41, the second detection set DS42, the third detection set DS43, the fourth detection set DS44 and the switch 490 may be formed within (or entirely embedded in) the substrate 110, for example, the base 111 (not illustrated) and/or the dielectric layers 112 (not illustrated) of the substrate 110. In other words, at least one of the first detection set DS41, the second detection set DS42, the third detection set DS43, the fourth detection set DS44 and the switch 490 is not exposed from the semiconductor device 100.

As illustrated in FIG. 4, the first detection set DS41 includes the outer detection wire 420, the inner detection wire 430, a first outer connection wire 460A, a first inner connection wire 470A and a first inner-outer connection wire 435A. The first outer connection wire 460A connects the switch 490 with a first end 421 of the outer detection wire 420. The first inner connection wire 470A connects a switch unit 491 of the switch 490 with a second end 431 of the inner detection wire 430. The first inner-outer connection wire 435A connects the outer detection wire 420 with the inner detection wire 430.

As illustrated in FIG. 4, in the first detection set DS41, the outer detection wire 420 extends adjacent to the first sub-periphery lateral surface 110s1 and the second sub-periphery lateral surface 110s2, the inner detection wire 430 extends adjacent to the first sub-periphery lateral surface 110s1 and the second sub-periphery lateral surface 110s2. In the first detection set DS41, the outer detection wire 420 and the inner detection wire 430 may extend in the first extension path substantial parallel to the first sub-periphery lateral surface 110s1 and the second sub-periphery lateral surface 110s2. In the first detection set DS41, the first inner-outer connection wire 435A may extend in the second extension path substantial vertical to the second sub-periphery lateral surface 110s2.

As illustrated in FIG. 4, the second detection set DS42 includes the outer detection wire 420, the inner detection wire 430, the first outer connection wire 460A, the first inner connection wire 470A and the first inner-outer connection wire 435A. The first outer connection wire 460A connects the switch 490 with the first end 421 of the outer detection wire 420. The first inner connection wire 470A connects a switch unit 492 of the switch 490 with the second end 431 of the inner detection wire 430. The first inner-outer connection wire 435A connects the outer detection wire 420 with the inner detection wire 430.

As illustrated in FIG. 4, in the second detection set DS42, the outer detection wire 420 extends adjacent to the second sub-periphery lateral surface 110s2 and the third sub-periphery lateral surface 110s3, the inner detection wire 430 extends adjacent to the second sub-periphery lateral surface 110s2 and the third sub-periphery lateral surface 110s3. In the second detection set DS42, the outer detection wire 420 and the inner detection wire 430 may extend in the first extension path substantial parallel to the second sub-periphery lateral surface 110s2 and the third sub-periphery lateral surface 110s3. In the second detection set DS42, the first inner-outer connection wire 435A may extend in the second extension path substantial vertical to the second sub-periphery lateral surface 110s2.

As illustrated in FIG. 4, the third detection set DS43 includes the outer detection wire 420, the inner detection wire 430, the first outer connection wire 460A, the first inner connection wire 470A and the first inner-outer connection wire 435A. The first outer connection wire 460A connects the switch 490 with the first end 421 of the outer detection wire 420. The first inner connection wire 470A connects a switch unit 493 of the switch 490 with the second end 431 of the inner detection wire 430. The first inner-outer connection wire 435A connects the outer detection wire 420 with the inner detection wire 430.

As illustrated in FIG. 4, in the third detection set DS43, the outer detection wire 420 extends adjacent to the third sub-periphery lateral surface 110s3 and the fourth sub-periphery lateral surface 110s4, the inner detection wire 430 extends adjacent to the third sub-periphery lateral surface 110s3 and the fourth sub-periphery lateral surface 110s4. In the third detection set DS43, the outer detection wire 420 and the inner detection wire 430 may extend in the first extension path substantial parallel to the third sub-periphery lateral surface 110s3 and the fourth sub-periphery lateral surface 110s4. In the third detection set DS43, the first inner-outer connection wire 435A may extend in the third extension path substantial vertical to the third sub-periphery lateral surface 110s3.

As illustrated in FIG. 4, the fourth detection set DS44 includes the outer detection wire 420, the inner detection wire 430, the first outer connection wire 460A, the first inner connection wire 470A and the first inner-outer connection wire 435A. The first outer connection wire 460A connects the switch 490 with the first end 421 of the outer detection wire 420. The first inner connection wire 470A connects a switch unit 494 of the switch 490 with the second end 431 of the inner detection wire 430. The first inner-outer connection wire 435A connects the outer detection wire 420 with the inner detection wire 430.

As illustrated in FIG. 4, in the fourth detection set DS44, the outer detection wire 420 extends adjacent to the first sub-periphery lateral surface 110s1 and the fourth sub-periphery lateral surface 110s4, the inner detection wire 430 extends adjacent to the first sub-periphery lateral surface 110s1 and the fourth sub-periphery lateral surface 110s4. In the fourth detection set DS44, the outer detection wire 420 and the inner detection wire 430 may extend in the first extension path substantial parallel to the first sub-periphery lateral surface 110s1 and the fourth sub-periphery lateral surface 110s4. In the fourth detection set DS44, the first inner-outer connection wire 435A may extend in the fourth extension path substantial vertical to the fourth sub-periphery lateral surface 110s4.

The switch 490 may be disposed in or on the substrate 110. In certain embodiments, the switch 490 may be part of a circuit substrate (not shown), such as a printed circuit board or the like. The circuit substrate is electrically connected to the semiconductor device 400. The switch 490 may control one of the switch units 491, 492, 493 and 494 to be turned on for detecting whether the corresponding detection wire is broken.

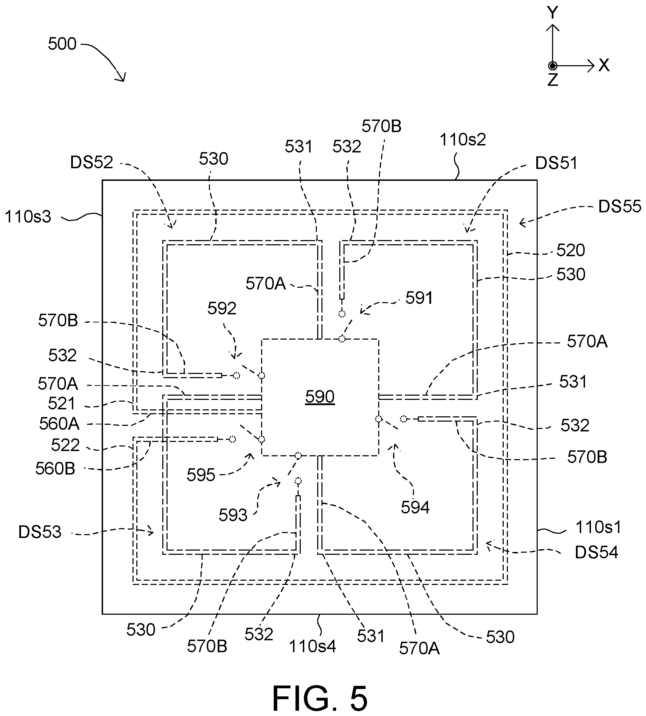

Referring to FIG. 5, FIG. 5 illustrates a schematic diagram of a top view of a semiconductor device 500 according to another embodiment of the invention. The semiconductor device 500 includes the substrate 110, an outer detection wire 520, a first detection set DS51, a second detection set DS52, a third detection set DS53, a fourth detection set DS54 and a switch 590. Each of the first detection set DS51, the second detection set DS52, the third detection set DS53 and the fourth detection set DS54 includes an inner detection wire 530. The inner detection wire 530 may include the feature the same as or similar to that of the outer detection wire 130 or the outer detection wire 230.

As illustrated in FIG. 5, the outer detection wire 520 extends adjacent to the first sub-periphery lateral surface 110s1, the second sub-periphery lateral surface 110s2, the third sub-periphery lateral surface 110s3 and the fourth sub-periphery lateral surface 110s4. The outer detection wire 520 may extend in the first extension path substantial parallel to the first sub-periphery lateral surface 110s1, the second sub-periphery lateral surface 110s2, the third sub-periphery lateral surface 110s3 and the fourth sub-periphery lateral surface 110s4.

In the present embodiment, at least one of the first detection set DS51, the second detection set DS52, the third detection set DS53, the fourth detection set DS54 and the switch 590 may be formed within (or entirely embedded in) the substrate 110, for example, the base 111 (not illustrated) and/or the dielectric layers 112 (not illustrated) of the substrate 110. In other words, at least one of the first detection set DS51, the second detection set DS52, the third detection set DS53, the fourth detection set DS54 and the switch 590 is not exposed from the semiconductor device 500.

As illustrated in FIG. 5, the first detection set DS51 includes the inner detection wire 530, a first inner connection wire 570A and a second inner connection wire 570B. The first inner connection wire 570A connects the switch 590 with a first end 531 of the inner detection wire 530. The second inner connection wire 570B connects a switch unit 591 of the switch 590 with a second end 532 of the inner detection wire 530.

In the present embodiment, the first inner connection wire 570A and/or the second inner connection wire 570B may include the features the same as or similar to that of the inner detection wire 130 or the inner detection wire 230.

As illustrated in FIG. 5, in the first detection set DS51, the inner detection wire 530 extends adjacent to the first sub-periphery lateral surface 110s1 and the second sub-periphery lateral surface 110s2, In the first detection set DS51, the inner detection wire 530 may extend in the first extension path substantial parallel to the first sub-periphery lateral surface 110s1 and the second sub-periphery lateral surface 110s2.

As illustrated in FIG. 5, the second detection set DS52 includes the inner detection wire 530, the first inner connection wire 570A and the second inner connection wire 570B. The first inner connection wire 570A connects the switch 590 with the first end 531 of the inner detection wire 530. The second inner connection wire 570B connects a switch unit 592 of the switch 590 with the second end 532 of the inner detection wire 530.

As illustrated in FIG. 5, in the second detection set DS52, the inner detection wire 530 extends adjacent to the second sub-periphery lateral surface 110s2 and the third sub-periphery lateral surface 110s3, In the second detection set DS52, the inner detection wire 530 may extend in the first extension path substantial parallel to the second sub-periphery lateral surface 110s2 and the third sub-periphery lateral surface 110s3.

As illustrated in FIG. 5, the third detection set DS53 includes the inner detection wire 530, the first inner connection wire 570A and the second inner connection wire 570B. The first inner connection wire 570A connects the switch 590 with the first end 531 of the inner detection wire 530. The second inner connection wire 570B connects a switch unit 593 of the switch 590 with the second end 532 of the inner detection wire 530.

As illustrated in FIG. 5, in the third detection set DS53, the inner detection wire 530 extends adjacent to the third sub-periphery lateral surface 110s3 and the fourth sub-periphery lateral surface 110s4, In the third detection set DS53, the inner detection wire 530 may extend in the first extension path substantial parallel to the third sub-periphery lateral surface 110s3 and the fourth sub-periphery lateral surface 110s4.

As illustrated in FIG. 5, the fourth detection set DS54 includes the inner detection wire 530, the first inner connection wire 570A and the second inner connection wire 570B. The first inner connection wire 570A connects the switch 590 with the first end 531 of the inner detection wire 530. The second inner connection wire 570B connects a switch unit 594 of the switch 590 with the second end 532 of the inner detection wire 530.

As illustrated in FIG. 5, in the fourth detection set DS54, the inner detection wire 530 extends adjacent to the first sub-periphery lateral surface 110s1 and the fourth sub-periphery lateral surface 110s4, In the fourth detection set DS54, the inner detection wire 530 may extend in the first extension path substantial parallel to the first sub-periphery lateral surface 110s1 and the fourth sub-periphery lateral surface 110s4.

In certain embodiments like those illustrated in FIG. 5, the semiconductor device 500 may further include a fifth detection set DS55 which includes the outer detection wire 520, a first outer connection wire 560A and a second outer connection wire 560B. The first outer connection wire 560A connects the switch 590 with the first end 521 of the outer detection wire 520. The second outer connection wire 560B connects a switch unit 595 of the switch 590 with the second end 522 of the outer detection wire 520.

The switch 590 may control one of the switch units 591, 592, 593 and 593 to be turned on for detecting whether the corresponding detection wire is broken.

While the invention has been described in terms of what is presently considered to be the most practical and preferred embodiments, it is to be understood that the invention needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

## Claims

1. A semiconductor device (100 to 500), **characterized in that** the semiconductor device (100 to 500) comprises:
a substrate (110) having a periphery lateral surface (110s);
an outer detection wire (120 to 520) disposed on the substrate (110) and adjacent to the periphery lateral surface (110s); and
an inner detection wire (130 to 530) disposed on the substrate (110), adjacent to the periphery lateral surface (110s), and isolated from the outer detection wire (120 to 520);
wherein the outer detection wire (120 to 520) is closer to the periphery lateral surface (110s) than the inner detection wire (130 to 530).

2. The semiconductor device (100 to 500) as claimed in claim 1, **characterized in that** the semiconductor device (100 to 500) the outer detection wire (120 to 520) extends in a first extension path substantial parallel to the periphery lateral surface (110s).

3. The semiconductor device (100 to 500) as claimed in claim 1, **characterized in that** the semiconductor device (100 to 500) comprises:
a first pad (140A) disposed on and exposed from the substrate (110);
a first outer connection wire (160A, 460A) connecting the first pad (140A) with a first end (122, 221, 421) of the outer detection wire (120 to 520);
a second pad (140B) disposed on and exposed from the substrate (110); and
a second outer connection wire (160B) connecting the second pad (140B) with a second end (122, 222) of the outer detection wire (120 to 520).

4. The semiconductor device (100 to 500) as claimed in claim 1, **characterized in that** the semiconductor device (100 to 500) comprises:
a third pad (150A) disposed on and exposed from the substrate (110);
a first inner connection wire (170A, 370A, 470A, 570A) connecting the third pad (150A) with a first end of the inner detection wire (130 to 530);
a fourth pad (150B) disposed on and exposed from the substrate (110); and
a second inner connection wire (170B, 370B, 570B) connecting the fourth pad (150B) with a second end (132, 232, 431, 532) of the inner detection wire (130 to 530).

5. The semiconductor device (100 to 500) as claimed in claim 1, **characterized in that** the substrate (110) comprises:
a plurality of dielectric layers (112, 112', 112") stacked to each other;
wherein the outer detection wire (120 to 520) comprises a plurality of conductive traces (123, 133) and a plurality of conductive vias (124, 134), each conductive trace (123, 133) is disposed on the corresponding dielectric layer (112, 112', 112"), and one of the conductive vias (124, 134) connects the adjacent two of the conductive traces (123, 133).

6. The semiconductor device (100 to 500) as claimed in claim 1, **characterized in that** the outer detection wire (120 to 520) comprises an outer ascending segment (120A', 220A, 220A') and an outer descending segment (120D, 120D', 220D, 220D') connected with the outer ascending segment (120A', 220A, 220A'), and the inner detection wire (130 to 530) comprises an inner ascending segment (130A, 130A', 230A, 230A') and an inner descending segment (130D, 130D', 230D, 230D') connected with the inner ascending segment (130A, 130A', 230A, 230A');
wherein the outer ascending segment (120A', 220A, 220A') is corresponding to the inner descending segment (130D, 130D', 230D, 230D'), and the outer descending segment (120D, 120D', 220D, 220D') is corresponding to the inner ascending segment (130A, 130A', 230A, 230A').

7. The semiconductor device (100 to 500) as claimed in claim 1, **characterized in that** the outer detection wire (120 to 520) comprises an outer ascending segment (120A', 220A, 220A') and an outer descending segment (120D, 120D', 220D, 220D') connected with the outer ascending segment (120A', 220A, 220A'), and the inner detection wire (130 to 530) comprises an inner ascending segment (130A, 130A', 230A, 230A') and an inner descending segment (130D, 130D', 230D, 230D') connected with the inner ascending segment (130A, 130A', 230A, 230A');
wherein the outer ascending segment (120A', 220A, 220A') is corresponding to the inner ascending segment (130A, 130A', 230A, 230A'), and the outer descending segment (120D, 120D', 220D, 220D') is corresponding to the inner descending segment (130D, 130D', 230D, 230D').

8. The semiconductor device (100 to 500) as claimed in claim 1, **characterized in that** the semiconductor device (100 to 500) comprises:
a first detection set (DS31, DS41, DS51) and a second detection set (DS32, DS42, DS52), wherein each of the first detection set (DS31, DS41, DS51) and the second detection set (DS32, DS42, DS52) comprises the outer detection wire (120 to 520) and the inner detection wire (130 to 530);
wherein the periphery lateral surface (110s) has a first sub-periphery lateral surface (110s1), a second sub-periphery lateral surface (110s2), a third sub-periphery lateral surface (110s3) opposite to the first sub-periphery lateral surface (110s1) and a fourth sub-periphery lateral surface (110s4) opposite to the second sub-periphery lateral surface (110s2); the first detection set (DS31, DS41, DS51) extends adjacent to the first sub-periphery lateral surface (110s1), the second sub-periphery lateral surface (110s2) and the fourth sub-periphery lateral surface (110s4), and the second detection set (DS32, DS42, DS52) extends adjacent to the second sub-periphery lateral surface (110s2), the third sub-periphery lateral surface (110s3) and the fourth sub-periphery lateral surface (110s4).

9. The semiconductor device (100 to 500) as claimed in claim 1, **characterized in that** the semiconductor device (100 to 500) comprises:
a first detection set (DS31, DS41, DS51), a second detection set (DS32, DS42, DS52), a third detection set (DS43, DS53) and a fourth detection set (DS44, DS54), wherein each of the first detection set (DS31, DS41, DS51), the second detection set (DS32, DS42, DS52), the third detection set (DS43, DS53) and the fourth detection set (DS44, DS54) comprises the outer detection wire (120 to 520) and the inner detection wire (130 to 530);
wherein the periphery lateral surface (110s) has a first sub-periphery lateral surface (110s1), a second sub-periphery lateral surface (110s2), a third sub-periphery lateral surface (110s3) opposite to the first sub-periphery lateral surface (110s1) and a fourth sub-periphery lateral surface (110s4) opposite to the second sub-periphery lateral surface (110s2); the first detection set (DS31, DS41, DS51) extends adjacent to the first sub-periphery lateral surface (110s1) and the second sub-periphery lateral surface (110s2), the second detection set (DS32, DS42, DS52) extends adjacent to the second sub-periphery lateral surface (110s2) and the third sub-periphery lateral surface (110s3), the third detection set (DS43, DS53) extends adjacent to the third sub-periphery lateral surface (110s3) and the fourth sub-periphery lateral surface (110s4), and the fourth detection set (DS44, DS54) extends adjacent to the fourth sub-periphery lateral surface (110s4) and the first sub-periphery lateral surface (110s1).

10. The semiconductor device (100 to 500) as claimed in claim 9, **characterized in that** the semiconductor device (100 to 500) comprises:
a switch (490, 590) disposed on the substrate (110) and electrically connected with the first detection set (DS31, DS41, DS51), the second detection set (DS32, DS42, DS52), the third detection set (DS43, DS53) and the fourth detection set (DS44, DS54).

11. The semiconductor device (100 to 500) as claimed in claim 9, **characterized in that** each of the first detection set (DS31, DS41, DS51), the second detection set (DS32, DS42, DS52), the third detection set (DS43, DS53) and the fourth detection set (DS44, DS54) comprises:
the outer detection wire (120 to 520);
the inner detection wire (130 to 530);
a first outer connection wire (160A, 460A) connected with a first end (122, 221, 421) of the outer detection wire (120 to 520);
a first inner connection wire (170A, 370A, 470A, 570A) connected with a second end (132, 232, 431, 532) of the inner detection wire (130 to 530); and
a first inner-outer connection wire (335A, 435A) connecting the outer detection wire (120 to 520) with the inner detection wire (130 to 530).

12. The semiconductor device (100 to 500) as claimed in claim 10, **characterized in that** each of the first detection set (DS31, DS41, DS51), the second detection set (DS32, DS42, DS52), the third detection set (DS43, DS53) and the fourth detection set (DS44, DS54) comprises:
the outer detection wire (120 to 520);
the inner detection wire (130 to 530);
a first outer connection wire (160A, 460A) connecting the switch (490, 590) with a first end (122, 221, 421) of the outer detection wire (120 to 520);
a first inner connection wire (170A, 370A, 470A, 570A) connecting a switch unit (491 to 494, 591 to 594) of the switch (490, 590) with a second end (132, 232, 431, 532) of the inner detection wire (130 to 530); and
a first inner-outer connection wire (335A, 435A) connecting the outer detection wire (120 to 520) with the inner detection wire (130 to 530).

13. The semiconductor device (100 to 500) as claimed in claim 1, **characterized in that** the semiconductor device (100 to 500) comprises:
an outer detection wire (120 to 520); and
a first detection set (DS31, DS41, DS51), a second detection set (DS32, DS42, DS52), a third detection set (DS43, DS53) and a fourth detection set (DS44, DS54), wherein each of the first detection set (DS31, DS41, DS51), the second detection set (DS32, DS42, DS52), the third detection set (DS43, DS53) and the fourth detection set (DS44, DS54) comprises the inner detection wire (130 to 530);
wherein the periphery lateral surface (110s) has a first sub-periphery lateral surface (110s1), a second sub-periphery lateral surface (110s2), a third sub-periphery lateral surface (110s3) opposite to the first sub-periphery lateral surface (110s1) and a fourth sub-periphery lateral surface (110s4) opposite to the second sub-periphery lateral surface (110s2); the outer detection wire (120 to 520) extends adjacent to the first sub-periphery lateral surface (110s1), the second sub-periphery lateral surface (110s2), the third sub-periphery lateral surface (110s3) and the fourth sub-periphery lateral surface (110s4); the first detection set (DS31, DS41, DS51) extends adjacent to the first sub-periphery lateral surface (110s1) and the second sub-periphery lateral surface (110s2), the second detection set (DS32, DS42, DS52) extends adjacent to the second sub-periphery lateral surface (110s2) and the third sub-periphery lateral surface (110s3), the third detection set (DS43, DS53) extends adjacent to the third sub-periphery lateral surface (110s3) and the fourth sub-periphery lateral surface (110s4), and the fourth detection set (DS44, DS54) extends adjacent to the fourth sub-periphery lateral surface (110s4) and the first sub-periphery lateral surface (110s1).

14. The semiconductor device (100 to 500) as claimed in claim 13, **characterized in that** the semiconductor device (100 to 500) comprises:
a switch (490, 590) disposed on the substrate (110) and electrically connected with the first detection set (DS31, DS41, DS51), the second detection set (DS32, DS42, DS52), the third detection set (DS43, DS53) and the fourth detection set (DS44, DS54).

15. The semiconductor device (100 to 500) as claimed in claim 13, **characterized in that** the first detection set (DS31, DS41, DS51), the second detection set (DS32, DS42, DS52), the third detection set (DS43, DS53) and the fourth detection set (DS44, DS54) are entirely embedded in the substrate (110).
